# EUROPÄISCHE PATENTSCHRIFT

(11) **EP 3 279 618 B1**
(45) Veröffentlichungstag und Bekanntmachung des Hinweises auf die Patenterteilung: **24.02.2021**
(21) Anmeldenummer: 16001694.5
(22) Anmeldetag: 01.08.2016
(51) Int. Cl.: G01F 11/00, G01F 11/28

(54) **KALIBRIEREINRICHTUNG UND VERFAHREN ZUR DOSIERUNG VON DARREICHUNGSEINHEITEN**
CALIBRATION DEVICE AND METHOD FOR DOSING OF DELIVERY UNITS
DISPOSITIF D'ETALONNAGE ET PROCEDE DE DOSAGE D'UNITES D'ADMINISTRATION

(43) Veröffentlichungstag der Anmeldung: 07.02.2018
(73) Patentinhaber: Harro Höfliger Verpackungsmaschinen GmbH, 71573 Allmersbach im Tal (DE)
(72) Erfinder: Lux, Andreas, 71573 Allmersbach im Tal (DE); Höpfer, Jonas, 71573 Allmersbach im Tal (DE); Kleine-König, Benedict, 71364 Winnenden (DE)
(74) Vertreter: Zurhorst, Stefan

(56) Entgegenhaltungen:
- WO-A2-2004/041435
- WO-A2-2010/099490
- US-A- 4 223 751
- US-A- 4 461 363
- US-A1- 2009 056 826
- US-A1- 2009 261 128

## Beschreibung

Die Erfindung betrifft eine Kalibriereinrichtung für ein kapazitives Messsystem, eine Dosiereinrichtung mit einem kapazitiven Messsystem und mit einer Kalibiereinrichtung sowie ein Verfahren zur Dosierung von insbesondere festen pharmazeutischen Darreichungseinheiten mittels der genannten Dosiereinrichtung.

Beispielsweise im pharmazeutischen Bereich kommt es auf eine exakte und wiederholbare Dosierung von Darreichungseinheiten an, damit der Patient exakt die vorgesehene Menge an Wirkstoff zu sich nimmt. Feste Darreichungsformen können beispielsweise Tabletten oder in Steckkapseln bereitgestellte Pulvermengen bzw. Pellets sein. Natürlich kommen auch beliebige andere feststoffartige Darreichungsformen in Betracht. Jedenfalls erfolgt die Dosierung solcher Darreichungseinheiten im Regelfall auf volumetrischem Wege, wobei über ein bestimmtes abgemessenes Volumen und die Dichte des Materials eine bestimmte Zielmasse angestrebt wird. Letztlich ist es aber nicht das Volumen, sondern die tatsächlich bei der Dosierung erzielte Masse der einzelnen Darreichungseinheiten, auf die es ankommt. Dichteschwankungen im Material, unvollständige Ausfüllungen bzw. Entleerungen der volumetrischen Messkammer oder dgl. können zu unerwünschten Schwankungen der Zielmasse führen. Insbesondere bei kritischen Wirkstoffen ist deshalb eine verlässliche Prozesskontrolle erforderlich.

Für die Kontrolle eines ordnungsgemäßen Ablaufes des Dosiervorganges kommen verschiedene Kontrollschritte in Betracht. Ein erster optionaler Kontrollschritt kann beispielsweise mittels einer kapazitiven Messstrecke vorgenommen werden. Diese kann qualitative Aussagen über den Dosierprozess hervorbringen und helfen, Prozessfehler zu lokalisieren. Für eine quantitative Kontrolle des Dosierergebnisses werden gravimetrische Messungen vorgenommen, in denen die zuvor volumetrisch abgemessenen Darreichungseinheiten einzeln gewogen werden. Für den statischen Vorgang des Wiegens müssen sich die einzelnen Darreichungseinheiten in Ruhe befinden. Dem stehen jedoch die hohen Bewegungsgeschwindigkeiten bei einer Dosierung im industriellen Maßstab entgegen. Eine mitunter erforderliche hundertprozentige In-Prozess-Kontrolle ist deshalb nur schwer und mit hohem Kostenaufwand zu realisieren.

Aus der US 2009/0056826 A1 sind eine Vorrichtung und ein Verfahren zur mengengesteuerten Abfüllung pulverförmiger Substanzen in Behältnisse bekannt. Eine vorbestimmte Pulvermenge fällt in ein Behältnis und wird während des Fallens durch einen kapazitiven Mengensensor auf Korrektheit geprüft. Vorab wird der Sensor mittels einer korrespondierenden Testmenge des Pulvers kalibriert.

Der Erfindung liegt die Aufgabe zugrunde, geeignete Mittel für eine zuverlässige und wiederholbare Massebestimmung von insbesondere festen pharmazeutischen Darreichungseinheiten bereitzustellen.

Diese Aufgabe wird durch eine Kalibriereinrichtung mit den Merkmalen des Anspruchs 1 und auch durch eine Dosiereinrichtung mit den Merkmalen des Anspruchs 7 gelöst.

Der Erfindung liegt des Weiteren die Aufgabe zugrunde, ein insbesondere großserientaugliches Dosierverfahren anzugeben, mittels dessen die gewünschten Zielmassen der Darreichungseinheiten zuverlässig und wiederholbar eingehalten werden können.

Diese Aufgabe wird durch ein Verfahren mit den Merkmalen des Anspruchs 10 gelöst.

Die Erfindung basiert auf dem Grundgedanken, ein kapazitives Messsystem einzusetzen und dieses in erfindungsgemäßer Weise derart zu kalibrieren, dass es mit ausreichender Genauigkeit und Zuverlässigkeit für die Massebestimmung der einzelnen zuvor abgemessenen Darreichungseinheiten eingesetzt werden kann.

Hierzu weist die erfindungsgemäße Dosiereinrichtung eine Kalibriereinrichtung, einen Prüfkörper, Antriebsmittel für den Prüfkörper sowie eine Führung für den Prüfkörper auf. Die Führung für den Prüfkörper umfasst eine erste Endposition, eine zweite Endposition und eine zwischen den beiden Endpositionen verlaufende Führungsstrecke für den Prüfkörper. Die Antriebsmittel sind dazu ausgelegt, den Prüfkörper entlang der Führungsstrecke zwischen den beiden Endpositionen hin und her zu bewegen. Für den Kalibriervorgang wird die genannte Führung im Messkanal des kapazitiven Messsystems positioniert. Der Prüfkörper, welcher zuvor ermittelte und bekannte dielektrische Eigenschaften aufweist, wird nun mindestens einmal, bevorzugt mehrmals entlang der Führungsstrecke zwischen den beiden Endpositionen hin und her bewegt, wobei er in entsprechender Anzahl die Messstrecke des kapazitiven Messsystems durchläuft. Der Prüfkörper wirkt dabei als Prüfnormal, wobei das zugehörige Messergebnis des kapazitiven Messsystems als Kalibriermesswert herangezogen wird. Mittels eines solchermaßen kalibrierten kapazitiven Messsystems werden nun die im regulären Betrieb abgemessenen Darreichungseinheiten beim Hindurchtritt durch die Messstrecke kapazitiv vermessen, wodurch in Verbindung mit der zuvor durchgeführten Kalibrierung eine exakte Massebestimmung der einzelnen Darreichungseinheiten möglich ist.

Es hat sich gezeigt, dass durch die erfindungsgemäßen Vorrichtungen bzw. durch das erfindungsgemäße Verfahren Messergebnisse mit außergewöhnlich genauen und wiederholbaren Messwerten erzielen lassen. Standardabweichungen innerhalb einer Messreihe von < 0,5 % sind ohne weiteres erzielbar. Zuverlässigkeit und Genauigkeit erfüllen die einschlägigen Zulassungsvoraussetzungen insbesondere im Pharmabereich. Auf statische und deshalb langsame Wägungen kann verzichtet werden. Vielmehr erfolgt die kalibrierte Massebestimmung dynamisch beim Durchtritt der Darreichungseinheit durch die Messstrecke des kapazitiven Messsystems, ohne dass der Dosiervorgang insgesamt verlangsamt wird. Somit lässt sich im Rahmen einer hundertprozentigen In-Prozess-Kontrolle eine Massebestimmung jeder einzelnen Darreichungseinheit vornehmen.

Für die Führung des Prüfkörpers kommen verschiedene Ausgestaltungen in Betracht. Bevorzugt ist die Führung ein den Prüfkörper umschließendes Führungsrohr, wodurch sich die Bewegung des Prüfkörpers sehr gut kontrollieren lässt. Bei entsprechender Anpassung an den Querschnitt des Messkanals kann das Führungsrohr auch als Zentriermittel für den Prüfkörper dienen, so dass dieser mit hoher Genauigkeit koaxial zum Messkanal geführt wird. Außerdem kann im Führungsrohr die Bewegungsgeschwindigkeit des Prüfkörpers exakt angepasst werden.

Die Antriebsmittel für den Prüfkörper sind gemäß der Erfindung als pneumatische Antriebsmittel ausgeführt. Hierbei kann es ausreichen, dass ein pneumatisch wirkender Luftstoß nur einseitig wirkt, während der Prüfkörper in Gegenrichtung beispielsweise unter Einwirkung der Schwerkraft zurückfällt. Zweckmäßig handelt es sich aber um beidseitig auf den Prüfkörper wirkende pneumatische Antriebsmittel, die eine exakte Geschwindigkeitsanpassung bzw. Geschwindigkeitseinstellung in beide Bewegungsrichtungen ermöglichen. Bevorzugt wird zunächst die Geschwindigkeit der Darreichungseinheiten beim Durchtritt durch die Messstrecke des kapazitiven Messsystems ermittelt. Beim Kalibriervorgang wird dann der Prüfkörper mit der zumindest näherungsweise gleichen Geschwindigkeit wie die zuvor ermittelte Durchtrittsgeschwindigkeit der Darreichungseinheiten bewegt. Dabei hat sich gezeigt, dass die gewünschten Geschwindigkeiten insbesondere mittels des pneumatischen Antriebs sehr exakt eingestellt werden können. Insgesamt kann hierdurch die Korrelation zwischen den Kalibriermessungen und den tatsächlichen Messungen im laufenden Dosierprozess verbessert werden.

In bevorzugter Weiterbildung ist der Prüfkörper aus Kunststoff und insbesondere aus PEEK (Polyetheretherketon). Das Gleiche gilt auch für das Material der Führung, welche ebenfalls aus einem solchen Kunststoff bestehen kann. Alternativ kann die Führung auch aus Glas sein, wobei jedoch auch andere Materialien in Betracht kommen. Jedenfalls liegen die dielektrischen Eigenschaften der bevorzugten Materialien nahe bei den dielektrischen Eigenschaften der zu dosierenden Materialien, was ebenfalls zu einer guten Korrelation zwischen den Kalibriermessungen und den späteren Betriebsmessungen beiträgt. Insbesondere sind der Prüfkörper und die Führung aus dem gleichen Material, was die Isolierung bzw. Trennung des durch den Prüfkörper erzeugten Signals vom Signaleinfluss der Führung vereinfacht.

Für die Kalibriereinrichtung kommen verschiedene Bauformen in Betracht. Insbesondere hat sich eine Bauform als zweckmäßig herausgestellt, bei der die Kalibriereinrichtung einen zangenförmigen Haltekörper mit zwei Haltearmen aufweist. Im Betrieb greift der zangenförmige Haltekörper um den Grundkörper des kapazitiven Messsystems derart, dass der eine Haltearm oberhalb des Grundkörpers und der andere Haltearm unterhalb des Grundkörpers zu liegen kommt. Die durch den Messkanal hindurchgeführte Führung des Prüfkörpers wird vom oberen und vom unteren Haltearm gehalten. Außerdem sind beide Haltearme mit je einem Teil der Antriebsmittel derart versehen, dass der Prüfkörper ausgehend von einem Haltearm in Richtung zum gegenüberliegenden Haltearm bewegt werden kann. Dort wird dann seine Bewegungsrichtung umgekehrt, so dass der Prüfkörper vom gegenüberliegenden Haltearm zurück in seine Ausgangsposition bewegt wird. Dieser Prozess kann in genügender Anzahl wiederholt werden, bis eine statistisch signifikante Anzahl von Messwerten ermittelt worden ist. Die genannte Zangenform erlaubt eine exakte und widerholbare Positionierung der Führung und des Prüfkörpers im Messkanal, während gleichzeitig sichergestellt ist, dass der Prüfkörper in beiden Bewegungsrichtungen mit der gewünschten Geschwindigkeit bewegt werden kann.

Ein Ausführungsbeispiel der Erfindung ist nachfolgend anhand der Zeichnung näher beschrieben. Es zeigen:
- Fig. 1: in einer schematischen Übersichtsdarstellung eine erfindungsgemäße Dosiereinrichtung für die Dosierung von Darreichungseinheiten mit einem kapazitiven Messsystem und einer zugehörigen Kalibriereinrichtung, und
- Fig. 2: die nach Fig. 1 kalibrierte Dosiereinrichtung im regulären Dosierbetrieb in Verbindung mit einer kapazitiven Massenprüfung der einzelnen Darreichungseinheiten.

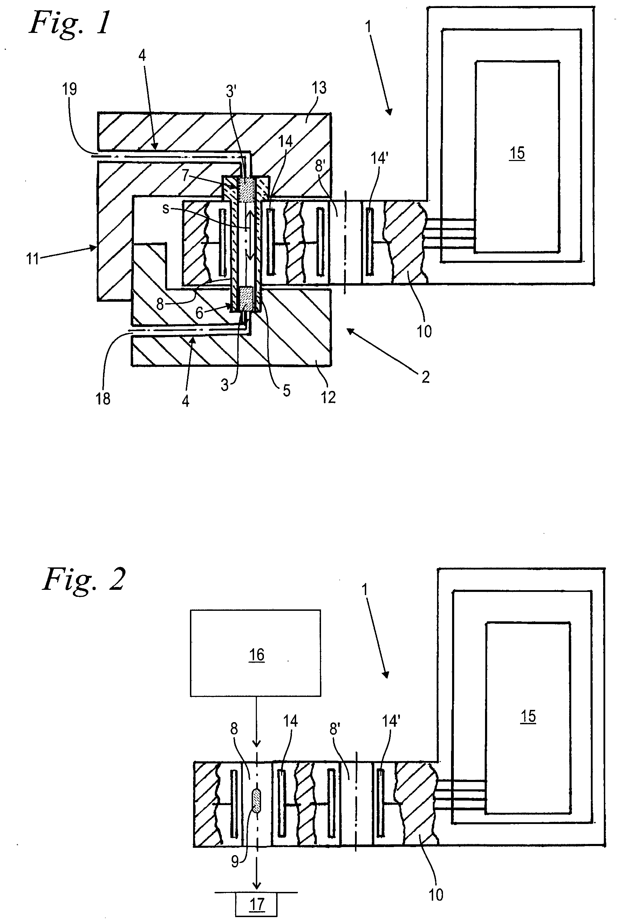

Die Fig. 1 und 2 zeigen in Zusammenschau eine schematische Schnittdarstellung der erfindungsgemäßen Dosiereinrichtung in zwei verschiedenen Konfigurationen. Die erfindungsgemäße Dosiereinrichtung umfasst neben einer schematisch angedeuteten Dosiereinheit 16 (Fig. 2), ein kapazitives Messsystem 1 sowie eine Kalibriereinrichtung 2 (Fig. 1) für das kapazitive Messsystem 1. Die Dosiereinrichtung ist dazu ausgelegt, insbesondere feste pharmazeutische Darreichungseinheiten 9 (Fig. 2) zu dosieren, hinsichtlich der tatsächlich erzielten Masse einer einzelnen Darreichungseinheit 9 zu prüfen und in einen Zielbehälter 17 zu überführen. Die genannten pharmazeutischen Darreichungseinheiten 9 können Tabletten, Pellets, komprimierte Pulverpfropfen oder dergleichen sein. Als Zielbehälter 17 (Fig. 2) kommen Blisterverpackungen, Steckkapseln oder dergleichen, aber auch beispielsweise Zwischenbehälter für eine Weiterverarbeitung in Betracht.

Zunächst wird auf Fig. 2 Bezug genommen, in der die erfindungsgemäße Dosiereinrichtung in gewöhnlicher Betriebskonfiguration gezeigt ist. In der nur schematisch angedeuteten Dosiereinheit 16 erfolgt eine insbesondere volumetrische Dosierung einer abgemessenen Teilmenge beispielsweise eines Pulvers oder eines Granulats unter Bildung einer schematisch angedeuteten Darreichungseinheit 9. Diese Darreichungseinheit 9 kann aus der Dosiereinheit 16 zum Zielbehälter 17 hin ausgeblasen werden. Alternativ oder zusätzlich kann die Gewichtskraft genutzt werden, um die Darreichungseinheit 9 aus der Dosiereinheit 16 in den Zielbehälter 17 fallen zu lassen.

Für eine hundertprozentige In-Prozess-Kontrolle passieren die einzelnen Darreichungseinheiten 9 auf ihrem Weg von der Dosiereinheit 16 zum Zielbehälter 17 die Messstrecke des eingangs schon erwähnten kapazitiven Messsystems 1. Das kapazitive Messsystem 1 umfasst hierfür einen Grundkörper 10 mit mindestens einem darin ausgebildeten, hier vertikal in Gewichtskraftrichtung ausgerichteten Messkanal 8. Im Messkanal 8 befindet sich die Messstrecke eines schematisch angedeuteten kapazitiven Messaufnehmers 14, welcher mit einer Auswerteeinheit 15 verbunden ist. Infolge einer weiter unten noch beschriebenen Kalibrierung des kapazitiven Messsystems 1 kann anhand des durch den kapazitiven Messaufnehmer 14 aufgenommenen, vom Durchtritt der Darreichungseinheit 9 erzeugten Messsignals in der Auswerteeinheit 15 die Masse jeder einzelnen Darreichungseinheit 9 mit hoher Präzision und Wiederholgenauigkeit bestimmt werden.

Optional kann parallel zum Messkanal 8 ein weiterer Messkanal 8' mit einem weiteren kapazitiven Messaufnehmer 14' angeordnet werden. Dabei wird dieser zusätzliche Messkanal 8' als Kompensationskanal zur Kompensierung beispielsweise von atmosphärischen Veränderungen eingesetzt, so dass letztere ohne Einfluss auf das ermittelte Messergebnis bleiben. Des Weiteren ist noch anzumerken, dass hier der Einfachheit halber nur ein Paar von Messkanälen 8, 8' mit kapazitiven Messaufnehmern 14, 14' gezeigt ist. In der Praxis wird eine mehrreihige Dosiereinheit 16 mit beispielsweise zwölf nebeneinander liegenden Dosierauslässen eingesetzt. Dementsprechend ist dann im Grundkörper 10 des kapazitiven Messsystems 1 eine korrespondierende Anzahl von Messkanälen 8 und ggf. auch von zusätzlichen Messkanälen 8' ausgebildet.

Damit aus dem Messergebnis des kapazitiven Messsystems 1 tatsächlich auch eine zuverlässige Aussage über die tatsächlich erreichte Masse jeder einzelnen Darreichungseinheit 9 getroffen werden kann, ist nach der Erfindung eine Kalibriereinrichtung 2 und ein zugehöriges Kalibrierverfahren für die Kalibrierung des kapazitiven Messsystems 1 vorgesehen, wie es sich aus der schematischen Darstellung nach Fig. 1 ergibt. Hier ist zur besseren Übersicht unter Weglassung der Dosiereinheit 16 und des Zielbehälters 17 das kapazitive Messsystem 1 nach Fig. 2 im Zusammenwirken mit der erfindungsgemäßen Kalibriereinrichtung 2 dargestellt. Die Kalibriereinrichtung 2 umfasst einen Prüfkörper 3, Antriebsmittel 4 für den Prüfkörper 3 sowie eine Führung 5 für den Prüfkörper 3. Für den Kalibrierprozess ist die Führung 5 derart im Messkanal 8 positioniert, dass der Prüfkörper 3 durch die Messstrecke des kapazitiven Messaufnehmers 4 bewegt werden kann. Dabei kann es ausreichen, die Führung 5 von nur einer Seite aus in den Messkanal 8 hineinragen zu lassen. Im gezeigten bevorzugten Ausführungsbeispiel ist die Führung 5 vollständig durch den Messkanal 8 hindurchgeführt und beidseitig gehalten. Hierzu weist die Kalibriereinrichtung 2 einen zangenförmigen Haltekörper 11 mit zwei Haltearmen 12, 13 auf, wobei im Kalibrierbetrieb gemäß Fig. 1 der eine Haltearm 12 unterhalb und der andere Haltearm 13 oberhalb des Grundkörpers 10 angeordnet sind. Beide Haltearme 11, 12 sind in ihrem axialen Abstand zueinander einstellbar, so dass sie den Grundkörper 10 des kapazitiven Messsystems 1 im Bereich des Messkanals 8 eng umschließen. Die Führung 5 für den Prüfkörper 3 ist oberhalb des Grundkörpers 10 am oberen Haltearm 13 und unterhalb davon am unteren Haltearm 12 gehalten. Ergänzend kann es noch zweckmäßig sein, eine identische Führung 5, jedoch ohne Prüfkörper 3 in den zusätzlichen, zur Kompensation vorgesehenen Messkanal 8' einzuführen.

Die Führung 5 kann eine Schiene oder dergleichen sein und ist im gezeigten Ausführungsbeispiel als ein den Prüfkörper 3 umschließendes Führungsrohr ausgebildet. Das Führungsrohr entspricht in seiner Außenkontur insoweit der Querschnittskontur des Messkanals 8, als hierdurch Zentriermittel für eine Zentrierung der Führung 5 im Messkanal 8 gebildet sind. Es kann aber auch zweckmäßig sein, den Außendurchmesser des Führungsrohres kleiner zu wählen als den Innendurchmesser des Messkanals 8. In diesem Falle ist der Einsatz von separaten Zentriermitteln zweckmäßig. Die Führung 5 bzw. das Führungsrohr selbst umschließt den Prüfkörper 3 mit so geringem Spiel, dass sich der Prüfkörper 3 mit ausreichender Genauigkeit entlang der Längsachse des Messkanals 8 bewegen lässt.

In Fig. 1 ist der Prüfkörper 3 in einer unteren Endposition 6 dargestellt, wozu im Haltekörper 11 ein entsprechender, nach unten auf den Prüfkörper 3 wirkender Anschlag ausgebildet ist. Am gegenüberliegenden Ende der Führung 5 bzw. des Führungsrohres befindet sich eine weitere, obere Endposition 7 mit einem in Gegenrichtung wirkenden Anschlag für den Prüfkörper 3. Zwischen den beiden Endpositionen 6, 7 verläuft eine Führungsstrecke s. Der Prüfkörper 3 kann ausgehend von seiner unteren Endposition 6 entlang der Führungsstrecke s bewegt werden, wo er dann mit 3' bezeichnet am Anschlag der oberen Endposition 7 zu liegen kommt, und von wo aus er zurück zu seiner Ausgangsposition in Form der unteren Endposition 6 bewegt werden kann. Mit anderen Worten wird der Prüfkörper 3 entlang der Führungsstrecke s zwischen beiden Endpositionen 6, 7 hin und her bewegt. Im gezeigten bevorzugten Ausführungsbeispiel verläuft die Führungsstrecke s vertikal. Es kann aber auch eine geneigte oder sogar eine horizontale Ausrichtung des Messkanals 8 und der Führungsstrecke s zweckmäßig sein. Jedenfalls verläuft die Führungsstrecke s achsparallel und insbesondere koaxial zur Längsachse des Messkanals 8, was gleichermaßen auch für die Bewegungsrichtung des Prüfkörpers 3 gilt.

Die eingangs schon erwähnten Antriebsmittel 4 sind dazu ausgelegt, den Prüfkörper entlang der Führungsstrecke s zwischen den beiden Endpositionen 6, 7 hin und her zu bewegen. Hierzu können einseitig wirkende Antriebsmittel zweckmäßig sein, die den Prüfkörper 3 beispielsweise aus der unteren Endposition 6 zur oberen Endposition 7 anheben. Es kann dann ausreichen, dass der Prüfkörper 3 in Gegenrichtung infolge der wirkenden Gewichtskraft zurück in die untere Endposition 6 fällt. Im gezeigten bevorzugten Ausführungsbeispiel wirken die Antriebsmittel 4 beidseitig auf den Prüfkörper 3, so dass dieser aktiv in beide Richtungen hin und her bewegt wird. Hierzu können mechanische Stößel, elektromagnetische Antriebe oder dergleichen zweckmäßig sein. In der gezeigten bevorzugten Ausführungsform sind die Antriebsmittel als beidseitig auf den Prüfkörper 3 wirkende pneumatische Antriebsmittel ausgeführt. Hierzu sind beide Haltearme 12, 13 mit je einem Teil der Antriebsmittel 4 versehen. Dies bedeutet im Einzelnen, dass ein erster Druckluftkanal 18 durch den unteren Haltearm 12 zum unteren Ende des Führungsrohres 5 verläuft, während ein zweiter Druckluftkanal 19 im oberen Haltearm 13 ausgebildet ist und zum oberen Ende des Führungsrohrs bzw. zur Führung 5 verläuft. Mittels einer nicht dargestellten Steuerventileinrichtung kann nun aus einer ebenfalls nicht dargestellten Druckluftquelle wechselseitig Druckluft in eine der beiden Druckluftkanäle 18, 19 eingespeist werden, in dessen Folge der Prüfkörper 3 innerhalb des Führungsrohres zwischen seinen beiden Endpositionen 6, 7 hin und her bzw. auf und ab geblasen wird. Im Dosierbetrieb nach Fig. 2 wurde ermittelt, mit welcher Geschwindigkeit die Darreichungseinheiten 9 durch die Messstrecke der kapazitiven Messaufnehmer 14 hindurchtreten bzw. hindurchfallen. Im Kalibrierbetrieb nach Fig. 1 wird die Drucklufteinspeisung der Antriebsmittel 4 nun derart angepasst, dass sich der Prüfkörper 3 in der Führung 5 und damit durch die Messstrecke des kapazitiven Messaufnehmers 14 mit zumindest näherungsweise der gleichen Geschwindigkeit wie die Darreichungseinheit 9 hin und her bewegt wird.

Im gezeigten bevorzugten Ausführungsbeispiel sind der Prüfkörper 3 und die Führung 5 aus dem gleichen Material gefertigt. Die Führung 5 bzw. das hierfür vorgesehene Führungsrohr ist ebenso wie der Prüfkörper 3 aus Kunststoff, namentlich aus PEEK gebildet. Es können aber auch andere Materialien zweckmäßig sein. Beispielsweise für sehr dünne Führungsrohre in sehr engen Messkanälen 8 kann Glas als Material zweckmäßig sein. Jedenfalls sind Materialien angestrebt, die in ihren auf die kapazitiven Messaufnehmer 14 wirkenden dielektrischen Eigenschaften möglichst nahe bei den dielektrischen Eigenschaften der Darreichungseinheiten 9 (Fig. 2) liegen.

Die Kalibrierung des kapazitiven Messsystems 1 wird in erfindungsgemäßer Weise wie folgt vorgenommen: Zunächst wird ein bestimmter und in seinen Eigenschaften bekannte Prüfkörper 3 mehrfach zwischen seinen Endpositionen 6, 7 hin und her bewegt. Die Führungsstrecke s ist dabei derart bemessen und positioniert, dass der Prüfkörper die wirksame Messtrecke des zugehörigen kapazitiven Messaufnehmers 4 vollständig durchläuft. Die dabei entstehenden Messsignale des kapazitiven Messaufnehmers 14 werden in der Auswerteeinheit 15 ausgewertet. Die Anzahl der Durchläufe des Prüfkörpers 3 durch die Messstrecke des kapazitiven Messaufnehmers 14 wird so hoch gewählt, dass die Auswertung der zugeordneten Einzelmessungen in der Auswerteeinheit 15 statistisch signifikant ist. Es hat sich als zweckmäßig herausgestellt, den gleichen Prüfkörper 3 mindestens 20mal, bevorzugt 30mal zwischen seinen beiden Endpositionen 6, 7 hin und her zu bewegen.

Bevorzugt wird der vorgenannte Vorgang nun mit mindestens zwei weiteren Prüfkörpern 3 wiederholt, wobei sich alle drei oder mehr zum Einsatz kommenden Prüfkörper 3 in einem die Masse beeinflussenden Parameter unterscheiden. Beispielsweise können die Prüfkörper 3 eine im Wesentlichen zylindrische Außenkontur aufweisen, wobei der Außendruckmesser gleich bleibt, jedoch die Länge der Prüfkörper 3 variiert wird. Die mindestens drei verschiedenen Längen ergeben dann eine korrespondierende Anzahl von Massen der Prüfkörper 3. Dies ermöglicht es, in der Auswerteeinheit 15 die Qualität der Messlinearität des kapazitiven Messsystems 1 innerhalb eines bestimmten Messbereichs zu ermitteln. Es erfolgt also nicht nur eine Kalibrierung für eine bestimmte Zielmasse, sondern für ein Messbereich der Masse, innerhalb dessen ausreichende Linearität vorliegt.

Um die Kalibrierung für einen möglichst großen Messbereich durchzuführen, kann die Variation eines zusätzlichen masserelevanten Parameters des Prüfkörpers 3 zweckmäßig sein. Beispielsweise können im Wesentlichen rohrförmige Prüfkörper 3 zum Einsatz kommen, wobei neben der Länge auch die Wandstärke variiert werden kann. Damit kann beispielsweise eine Prüfmatrix von drei verschiedenen Längen mal drei verschiedenen Wandstärken des Prüfkörpers 3 abgearbeitet werden. Im vorgenannten Beispiel kommen dann neun verschiedene Prüfkörper 3 mit allen möglichen Kombinationen der drei verschiedenen Längen der drei verschiedenen Wandstärken zum Einsatz. Jeder dieser Prüfkörper 3 wird dann wie oben beschrieben mehrfach zwischen den Endpositionen 6, 7 hin und her bewegt, um eine signifikante Anzahl von Messergebnissen zu erhalten. Die Kombination von zwei Parametern mit je mindestens drei verschiedenen Werten ist hier nur beispielhaft angegeben. Es können auch drei oder mehr masserelevante Parameter des Prüfkörpers 3 variiert werden. Jedenfalls sollte jeder Parameter in jeweils mindestens drei Werten variiert werden, um hieraus nicht nur einen großen Messbereich abzuleiten, sondern um innerhalb des Messbereichs auch eine Aussage über die Qualität der Messlinearität treffen zu können.

Jedenfalls kommen Prüfkörper 3 mit bekannten dielektrischen Eigenschaften zum Einsatz, die als Messnormale herangezogen werden, so dass die damit im kapazitiven Messsystem 1 ermittelten Messwerte für eine Kalibrierung herangezogen werden können. Es hat sich gezeigt, dass infolge der erfindungsgemäßen Kalibrierung innerhalb einer großen Spanne von Massebereichen exakte, wiederholbare und zuverlässige Massebestimmungen einzelner Darreichungseinheiten 9 möglich sind.

## Patentansprüche

1. Kalibriereinrichtung (2) für ein kapazitives Messsystem (1) in einer Dosiereinrichtung für insbesondere feste pharmazeutische Darreichungseinheiten (9), wobei die Kalibriereinrichtung (2) einen Prüfkörper (3), Antriebsmittel (4) für den Prüfkörper (3) sowie eine Führung (5) für den Prüfkörper (3) mit einer ersten Endposition (6), mit einer zweiten Endposition (7) und mit einer zwischen den beiden Endpositionen (6, 7) verlaufenden Führungsstrecke (s) umfasst, **dadurch gekennzeichnet, dass** die Antriebsmittel (4) dazu ausgelegt sind, den Prüfkörper (3) entlang der Führungsstrecke (s) zwischen den beiden Endpositionen (6, 7) hin und her zu bewegen, und dass die Antriebsmittel (4) als mindestens einseitig auf den Prüfkörper (3) wirkende pneumatische Antriebsmittel ausgeführt sind.

2. Kalibriereinrichtung nach Anspruch 1,
**dadurch gekennzeichnet, dass** die Führung (5) ein den Prüfkörper (3) umschließendes Führungsrohr ist.

3. Kalibriereinrichtung nach Anspruch 1 oder 2,
**dadurch gekennzeichnet, dass** die Antriebsmittel (4) als beidseitig auf den Prüfkörper (3) wirkende pneumatische Antriebsmittel ausgeführt sind.

4. Kalibriereinrichtung nach einem der Ansprüche 1 bis 3,
**dadurch gekennzeichnet, dass** der Prüfkörper (3) aus Kunststoff und insbesondere aus PEEK ist.

5. Kalibriereinrichtung nach einem der Ansprüche 1 bis 4,
**dadurch gekennzeichnet, dass** die Führung (5) aus Kunststoff, insbesondere aus PEEK, oder aus Glas ist.

6. Kalibriereinrichtung nach einem der Ansprüche 1 bis 5,
**dadurch gekennzeichnet, dass** der Prüfkörper (3) und die Führung (5) aus dem gleichen Material sind.

7. Dosiereinrichtung zur Dosierung von insbesondere festen pharmazeutischen Darreichungseinheiten (9), umfassend ein kapazitives Messsystem (1) und eine Kalibriereinrichtung (2) nach einem der Ansprüche 1 bis 6, wobei das kapazitive Messsystem (1) einen Messkanal (8) für die Darreichungseinheiten (9) aufweist, und wobei die Führung (5) zur Positionierung im Messkanal (8) ausgelegt ist.

8. Dosiereinrichtung nach Anspruch 7,
**dadurch gekennzeichnet, dass** Zentriermittel für eine Zentrierung der Führung (5) im Messkanal (8) vorgesehen sind.

9. Dosiereinrichtung nach Anspruch 7 oder 8 ,
**dadurch gekennzeichnet, dass** das kapazitive Messsystem (1) einen Grundkörper (10) mit mindestens einem durchgehenden Messkanal (8) aufweist, und dass die Kalibriereinrichtung (2) einen zangenförmigen Haltekörper (11) mit zwei Haltearmen (12, 13) aufweist, wobei im Betrieb der eine Haltearm (12) unterhalb und der andere Haltearm (13) oberhalb des Grundkörpers (10) angeordnet sind und zwischen sich die durch den Messkanal (8) hindurchgeführte Führung (5) halten,
und wobei beide Haltearme (12, 13) mit je einem Teil der Antriebsmittel (4) versehen sind.

10. Verfahren zur Dosierung von insbesondere festen pharmazeutischen Darreichungseinheiten (9) mittels einer Dosiereinrichtung nach einem der Ansprüche 7 bis 9, umfassend folgende Verfahrensschritte:
- Das kapazitive Messsystem (1) wird mittels der Kalibriereinrichtung (2) kalibriert;
- Die Darreichungseinheiten (9) werden mittels der Dosiereinrichtung dosiert und dabei mittels des kalibrierten kapazitiven Messsystems (1) hinsichtlich ordnungsgemäß dosierter Masse geprüft.

11. Verfahren nach Anspruch 10,
**dadurch gekennzeichnet, dass** der Prüfkörper (3) entlang der Führungsstrecke (s) zwischen den beiden Endpositionen (6, 7) mehrfach hin und her bewegt wird.

12. Verfahren nach Anspruch 10 oder 11,
**dadurch gekennzeichnet, dass** die Geschwindigkeit der Darreichungseinheiten (9) beim Durchtritt durch die Messstrecke des kapazitiven Messsystems (1) ermittelt wird, und dass der Prüfkörper (3) mit der gleichen Geschwindigkeit wie die Darreichungseinheiten (9) bewegt wird.

## Claims

1. Calibration device (2) for a capacitive measuring system (1) in a dosing device for in particular solid pharmaceutical administration units (9), the calibration device (2) comprising a test body (3), drive means (4) for the test body (3) and a guide (5) for the test body (3) having a first end position (6), a second end position (7) and a guide track (s) extending between the two end positions (6, 7),
**characterised in that** the drive means (4) are designed to move the test body (3) to and fro along the guide track (s) between the two end positions (6, 7), and **in that** the drive means (4) are designed as pneumatic drive means acting on the test body (3) on at least one side.

2. Calibration device according to claim 1,
**characterised in that** the guide (5) is a guide tube enclosing the test body (3).

3. Calibration device according to claim 1 or 2,
**characterised in that** the drive means (4) are designed as pneumatic drive means acting on the test body (3) on both sides.

4. Calibration device according to any of claims 1 to 3,
**characterised in that** the test body (3) consists of plastic, in particular of PEEK.

5. Calibration device according to any of claims 1 to 4,
**characterised in that** the guide (5) consists of plastic, in particular of PEEK, or of glass.

6. Calibration device according to any of claims 1 to 5,
**characterised in that** the test body (3) and the guide (5) consist of the same material.

7. Dosing device for dosing in particular solid pharmaceutical administration units (9), comprising a capacitive measuring system (1) and a calibration device (2) according to any of claims 1 to 6, wherein the capacitive measuring system (1) has a measuring channel (8) for the administration units (9) and wherein the guide (5) is designed for positioning in the measuring channel (8).

8. Dosing device according to claim 7,
**characterised in that** centring means are provided for centring the guide (5) in the measuring channel (8).

9. Dosing device according to claim 7 or 8,
**characterised in that** the capacitive measuring system (1) has a base body (10) with at least one continuous measuring channel (8), and **in that** the calibration device (2) has a pincer-shaped holding body (11) with two holding arms (12, 13), wherein in operation the one holding arm (12) is located below and the other holding arm (13) is located above the base body (10) and the guide (5) routed through the measuring channel (8) is held in between, and wherein each of the holding arms (12, 13) is provided with a part of the drive means (4).

10. Method for dosing in particular solid pharmaceutical administration units (9) by means of a dosing device according to any of claims 7 to 9, the method comprising the following procedural steps:
- The capacitive measuring system (1) is calibrated by means of the calibration device (2);
- The administration units (9) are dosed by means of the dosing device while being checked for properly dosed mass by means of the calibrated capacitive measuring system (1).

11. Method according to claim 10,
**characterised in that** the test body (3) is moved to and fro several times along the guide track (s) between the two end positions (6, 7).

12. Method according to claim 10 or 11,
**characterised in that** the speed of the administration units (9) when passing through the measuring section the capacitive measuring system (1) is determined, and **in that** the test body (3) is moved at the same speed as the administration units (9).

## Revendications

1. Dispositif d'étalonnage (2) pour un système de mesure capacitif (1) dans un dispositif de dosage pour des unités d'administration pharmaceutiques (9) en particulier solides, dans lequel le dispositif d'étalonnage (2) comprend un corps d'essai (3), des moyens d'entraînement (4) pour le corps d'essai (3) ainsi qu'un guide (5) pour le corps d'essai (3) avec une première position de fin de course (6), avec une deuxième position de fin de course (7) et avec une trajectoire de guidage (s) s'étendant entre les deux positions de fin de course (6, 7),
**caractérisé en ce que** les moyens d'entraînement (4) sont conçus pour déplacer avec un mouvement de va-et-vient le corps d'essai (3) le long de la trajectoire de guidage (s) entre les deux positions de fin de course (6, 7), et **en ce que** les moyens d'entraînement (4) sont réalisés comme des moyens d'entraînement pneumatiques agissant au moins d'un côté sur le corps d'essai (3).

2. Dispositif d'étalonnage selon la revendication 1,
**caractérisé en ce que** le guide (5) est un tube de guidage entourant le corps d'essai (3).

3. Dispositif d'étalonnage selon la revendication 1 ou 2,
**caractérisé en ce que** les moyens d'entraînement (4) sont réalisés comme des moyens d'entraînement pneumatiques agissant des deux côtés sur le corps d'essai (3).

4. Dispositif d'étalonnage selon l'une des revendications 1 à 3,
**caractérisé en ce que** le corps d'essai (3) est en matière plastique et en particulier en PEEK.

5. Dispositif d'étalonnage selon l'une des revendications 1 à 4,
**caractérisé en ce que** le guide (5) est en matière plastique, en particulier en PEEK, ou en verre.

6. Dispositif d'étalonnage selon l'une des revendications 1 à 5,
**caractérisé en ce que** le corps d'essai (3) et le guide (5) se composent du même matériau.

7. Dispositif de dosage pour le dosage d'unités d'administration pharmaceutiques (9) en particulier solides, comprenant un système de mesure capacitif (1) et un dispositif d'étalonnage (2) selon l'une des revendications 1 à 6, dans lequel le système de mesure capacitif (1) comporte un canal de mesure (8) pour les unités d'administration (9), et dans lequel le guide (5) est conçu pour le positionnement dans le canal de mesure (8).

8. Dispositif de dosage selon la revendication 7,
**caractérisé en ce qu'**il est prévu des moyens de centrage pour un centrage du guide (5) dans le canal de mesure (8).

9. Dispositif de dosage selon la revendication 7 ou 8,
**caractérisé en ce que** le système de mesure capacitif (1) comporte un corps de base (10) avec au moins un canal de mesure continu (8), et **en ce que** le dispositif d'étalonnage (2) comporte un corps de retenue en forme de pince (11) avec deux bras de retenue (12, 13), dans lequel en fonctionnement un bras (12) est disposé au-dessous, et l'autre bras (13) au-dessus du corps de base (10) et ils retiennent entre eux le guidage (5) guidé à travers le canal de mesure (8), et dans lequel les deux bras de retenue (12, 13) sont pourvus chacun d'une partie des moyens d'entraînement (4).

10. Procédé pour le dosage d'unités d'administration pharmaceutiques (9) en particulier solides à l'aide d'un dispositif de dosage selon l'une des revendications 7 à 9, comprenant les étapes de procédé suivantes :
- le système de mesure capacitif (1) est étalonné à l'aide du dispositif d'étalonnage (2) ;
- les unités d'administration pharmaceutiques (9) sont dosées à l'aide du dispositif de dosage, en étant contrôlées à l'aide du système de mesure capacitif (1) étalonné, en ce qui concerne la masse dosée convenablement.

11. Procédé selon la revendication 10,
**caractérisé en ce que** le corps d'essai (3) est déplacé plusieurs fois avec un mouvement de va-et-vient le long de la trajectoire de guidage (s) entre les deux positions de fin de course (6, 7).

12. Procédé selon la revendication 10 ou 11,
**caractérisé en ce que** la vitesse des unités d'administration (9) est recherchée lors du passage à travers la trajectoire de mesure du système de mesure capacitif (1), et **en ce que** le corps d'essai (3) est déplacé à la même vitesse que les unités d'administration (9).
